(19) Europäisches Patentamt
European Patent Office
Office européen des brevets

(11) **EP 3 143 419 B1**

(12) **FASCICULE DE BREVET EUROPEEN**

(45) Date de publication et mention de la délivrance du brevet:
**18.09.2019 Bulletin 2019/38**

(21) Numéro de dépôt: **15723017.8**

(22) Date de dépôt: **13.05.2015**

(51) Int Cl.:
$G01R\ 33/035^{(2006.01)}$    $G01R\ 31/312^{(2006.01)}$

(86) Numéro de dépôt international:
**PCT/EP2015/060692**

(87) Numéro de publication internationale:
**WO 2015/173354 (19.11.2015 Gazette 2015/46)**

(54) **COMPOSANT SUPRACONDUCTEUR, AMPLIFICATEUR ASSOCIÉ**

SUPRALEITENDES BAUELEMENT UND ZUGEHÖRIGER VERSTÄRKER

SUPERCONDUCTING COMPONENT AND ASSOCIATED AMPLIFIER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2014 FR 1401080**

(43) Date de publication de la demande:
**22.03.2017 Bulletin 2017/12**

(73) Titulaire: **THALES**
**92400 Courbevoie (FR)**

(72) Inventeurs:
- **CRETE, Denis**
  **F-91767 Palaiseau (FR)**
- **MARCILHAC, Bruno, Jean-Luc, André**
  **F-91767 Palaiseau (FR)**
- **LEMAITRE, Yves, Eric, Jacques**
  **F-91767 Palaiseau (FR)**

(74) Mandataire: **Lavoix**
**2, place d'Estienne d'Orves**
**75441 Paris Cedex 09 (FR)**

(56) Documents cités:
JP-A- H07 174 834    JP-A- S57 132 072
US-A- 4 051 393    US-A- 4 149 097
US-A- 5 574 290    US-A1- 2011 065 585
US-B1- 6 320 369    US-B1- 6 690 162

- ERIKO TAKEDA ET AL: "STUDY ON THE OPERATION OF A DUAL CHANNEL DIGITAL SUPERCONDUCTING MULTIPLEXER READOUT. QUANTUM INTERFERENCE DEVICE WITH DIRECT-CURRENT-POWERED JOSEPHSON", APPLIED PHYSICS LETTERS, AMERICAN INSTITUTE OF PHYSICS, US, vol. 66, no. 12, 20 mars 1995 (1995-03-20), pages 1548-1550, XP000500917, ISSN: 0003-6951, DOI: 10.1063/1.113642

## Description

La présente invention concerne un composant supraconducteur. L'invention concerne également un amplificateur comportant un tel composant.

Les composants supraconducteurs sont utilisés dans de multiples applications dont la détermination des susceptibilités magnétiques de minuscules échantillons sur une large plage de température, la détection de la résonance nucléaire magnétique et quadripolaire, la mesure de la température à l'aide de mesures de bruit également appelée thermométrie de bruit, le biomagnétisme, la géophysique, le magnétisme des roches ou le paléomagnétisme.

Pour cela, il est fait usage de l'effet Josephson. Par définition, l'effet Josephson se manifeste par l'apparition d'un courant, également appelé supracourant, entre deux matériaux supraconducteurs séparés par une couche non supraconductrice, e.g. formée d'un matériau isolant ou métallique non supraconducteur. L'ensemble des deux matériaux supraconducteurs et de la couche est appelé une « jonction Josephson ».

L'apparition de ce courant s'explique par la théorie macroscopique de la supraconductivité développée par John Bardeen, Leon Cooper et Robert Schrieffer. Selon cette théorie, en-dessous de la température de transition supraconductrice, au moins une partie des électrons libres dans le matériau supraconducteur sont liés entre eux, de manière à former des paires d'électrons dites « paires de Cooper ».

La supraconductivité est un phénomène quantique macroscopique induisant un ordre à l'échelle macroscopique, ce qui a trois conséquences principales : une conductivité électrique infinie justifiant l'existence d'un courant permanent de paires de Cooper dans un anneau supraconducteur, la quantification du flux magnétique à travers un anneau supraconducteur résultant de l'application d'un champ magnétique et du courant induit dans l'anneau et l'effet Josephson aussi appelé effet tunnel Josephson. Pour expliquer ce dernier phénomène, considérons deux supraconducteurs séparés par une mince barrière isolante à travers laquelle les paires de Cooper peuvent passer par un effet tunnel quantique, en maintenant la cohérence de phase entre les deux supraconducteurs durant le processus. Josephson a montré que la différence $\delta$ entre les phases des fonctions d'onde des deux côtés de la jonction Josephson est en relation avec le supracourant I circulant à travers la barrière et la tension $V$ aux bornes de la jonction Josephson, par les relations suivantes :

$$\begin{cases} \sin\delta = \dfrac{I}{I_c} \\[2em] V = \dfrac{\Phi_0}{2\pi} \dfrac{\partial\delta}{\partial t} \end{cases}$$

Où:

- $I_C$ est le courant critique, qui est le supracourant continu maximal que peut supporter la jonction Josephson. Ce courant critique est lié à la transparence de la barrière et à la densité de paires de Cooper dans les électrodes.
- $\phi_O$ est le quantum de flux, qui est le rapport entre la constante de Planck et la charge électrique d'une paire de Cooper.

Dans une jonction Josephson, le courant de paires de Cooper contribue au transport électronique, mais en parallèle, il existe classiquement le courant d'électrons célibataires (« quasiparticules ») associé à un terme dissipatif caractérisé par une résistance $R_n$. Il en résulte une équation différentielle de premier ordre en $\delta$, qui peut se résoudre analytiquement pour donner l'évolution temporelle de $\delta$, ce qui donne après une moyenne temporelle l'équation suivante:

$$\langle V \rangle = \frac{\Phi_0}{2\pi}\left\langle\frac{\partial\delta}{\partial t}\right\rangle = V_C \sqrt{\left(\frac{I}{I_c}\right)^2 - 1}$$

Où $V_C = R_n . I_C$ est la tension caractéristique de la jonction Josephson.

Il est souhaitable de proposer des agencements de composants supraconducteurs permettant d'exploiter au mieux l'effet Josephson.

Pour cela, il est connu depuis la fin des années 60 d'utiliser un dispositif supraconducteur d'interférences quantiques, plus souvent désigné sous l'acronyme anglais SQUID, qui renvoie à « superconducting quantum interference device ».

Un SQUID est une boucle supraconductrice (piste fermée formée d'au moins un matériau supraconducteur, électriquement équivalente à une inductance de valeur L) interrompue par au moins une couche isolante, chaque interruption formant une jonction Josephson. Les grandeurs d'inductance *L* de la boucle supraconductrice et du ou des courants critiques *I$_C$* des jonctions Josephson sont liées par le rapport *R1* entre le produit *L.Ic* et le quantum de flux Φ$_0$. Ce rapport *R1* est de préférence compris entre 0,2 et 4. Cela se traduit mathématiquement par les relations suivantes :

$$RI = \frac{LI_C}{\Phi_0}$$

et 0,2 ≤ *R1* ≤ 4

Des circuits SQUID sont aussi décrits dans les documents suivants : le document JP-H 07 17 48 34 A, le document US 4 149 097 A, le document US 5 574 290 A, le document US 2011/0065585 A1, le document JP S 57 13 20 72 A, le document US 6 320 369 B1, le document US 4 051 393 A et un article d'Eriko TAKEDA et al. intitulé « Study on the opération of a dual channel digital superconducting quantum interférence device with direct-current-powered Josephson multiplexer readout », extrait du journal Applied Physics Letters, American Institute of Physics, paru le 20 mars 1995 dans le Volume 66 au numéro 12, pages 1548 à 1550.

Toutefois, l'agencement précité ne permet pas de contrôler avec précision le courant critique de la ou des jonctions Josephson utilisées dans le composant.

Il existe donc un besoin pour un composant supraconducteur comportant au moins une jonction Josephson dont la valeur du courant critique soit contrôlable.

A cet effet, l'invention propose un composant supraconducteur comprenant une première boucle supraconductrice, la première boucle supraconductrice comportant une première branche comprenant une première jonction Josephson et une deuxième branche, la deuxième branche comprend un premier dispositif supraconducteur à interférence quantique à courant continu, le premier dispositif supraconducteur à interférence quantique à courant continu comportant une deuxième jonction Josephson et une troisième jonction Josephson, un courant critique étant défini pour chaque jonction Josephson, le courant critique de la première jonction Josephson est supérieur à la valeur absolue de la différence entre le courant critique de la troisième jonction Josephson et le courant critique de la deuxième jonction Josephson et inférieur à la somme du courant critique de la deuxième jonction Josephson et du courant critique de la troisième jonction Josephson, le composant comprenant des moyens de génération de flux magnétique sous forme de pistes conductrices positionnées au regard des branches, une piste étant couplée au premier dispositif supraconducteur à interférence quantique, les moyens de génération de flux magnétique étant agencés de façon à injecter efficacement un flux magnétique dans la première boucle supraconductrice et le premier dispositif supraconducteur à interférence quantique à courant continu.

Dans un tel cas, les moyens de génération de flux magnétique sont ainsi un moyen de contrôler le courant de boucle de façon à ajuster le courant critique du premier dispositif supraconducteur à interférence quantique à courant continu.

Suivant des modes de réalisation particuliers, le composant comprend une ou plusieurs des caractéristiques suivantes, prise(s) isolément ou suivant toutes les combinaisons techniquement possibles :

- le composant comprend une quatrième jonction Josephson en parallèle avec une partie de la première branche et une partie de la deuxième branche, les deux parties formant une inductance de boucle en parallèle de la quatrième jonction Josephson.
- la deuxième branche comprend le premier dispositif supraconducteur à interférence quantique à courant continu, monté en parallèle avec une inductance de boucle formée par une partie de la première branche et une partie de la deuxième branche, l'ensemble étant monté en série avec une quatrième jonction Josephson dont le courant critique est égal au courant critique de la première jonction Josephson à 1% près. Il est possible de réaliser le composant avec un écart de courant critique plus grand que 1%, mais avec des performances réduites en terme d'amplitude de modulation.
- le composant comprend une cinquième jonction Josephson agencée pour que la première jonction Josephson et la cinquième jonction Josephson forment un deuxième dispositif supraconducteur à interférence quantique à courant continu distinct du premier dispositif supraconducteur à interférence quantique à courant continu.
- le composant comprend une cinquième jonction Josephson agencée pour que la première jonction Josephson et la cinquième jonction Josephson forment un deuxième dispositif supraconducteur à interférence quantique à courant continu distinct du premier dispositif supraconducteur à interférence quantique à courant continu, et une sixième jonction Josephson agencée pour que la quatrième jonction Josephson et la sixième jonction Josephson forment un troisième dispositif supraconducteur à interférence quantique à courant continu distinct du premier dispositif supraconducteur à interférence quantique à courant continu et du deuxième dispositif supraconducteur à interférence quantique.

- en définissant un second rapport, dont le numérateur est le produit de l'inductance de la deuxième boucle et du courant critique de la jonction équivalente au premier dispositif supraconducteur à interférence quantique à courant continu et le dénominateur est le quantum de flux, défini comme le rapport de la constante de Planck sur la charge électrique d'une paire de Cooper, le second rapport est compris entre 0,2 et 4, de préférence inférieur à 1.

En outre, l'invention se rapporte aussi à un amplificateur comprenant une entrée, deux sorties, la différence de potentiel entre les deux sorties correspondant à une amplification d'un signal imposé en entrée de l'amplificateur, deux premiers éléments supraconducteurs à interférence quantique, dits premier doublet, montés en différentiel et reliés chacun à une respective des sorties de l'amplificateur, les deux éléments supraconducteurs à interférence quantique du premier doublet étant choisis parmi un composant tel que précédemment décrit et un dispositif supraconducteur à interférence quantique à courant continu, ou deux composants tels que précédemment décrits, et un moyen de contrôle de la différence de flux magnétique appliqué aux deux éléments supraconducteurs à interférence quantique du premier doublet.

Suivant des modes de réalisation particuliers, l'amplificateur comprend une ou plusieurs des caractéristiques suivantes, prise(s) isolément ou suivant toutes les combinaisons techniquement possibles :

- sont interposés entre les deux premiers doublets et les deux sorties : au moins deux deuxièmes doublets comprenant deux éléments supraconducteurs à interférence quantique montés en différentiel, et reliés chacun à une respective des sorties de l'amplificateur, les deux éléments supraconducteurs à interférence quantique de chaque deuxième doublet étant choisis parmi un composant tel que décrit précédemment et un dispositif supraconducteur à interférence quantique à courant continu, ou deux composants tels que précédemment décrits, et un moyen de contrôle de la différence de flux magnétique appliqué aux deux éléments supraconducteurs à interférence quantique de chaque deuxième doublet.

D'autres caractéristiques et avantages de l'invention apparaîtront à la lecture de la description détaillée qui suit, de modes de réalisation de l'invention, donnés à titre d'exemple uniquement et en références aux dessins qui sont :

- figure 1, un schéma d'implémentation d'un composant supraconducteur selon un premier mode de réalisation de l'invention ;
- figure 2, un schéma électrique équivalent au composant selon le premier mode de réalisation ;
- figure 3, un graphique montrant l'évolution de la phase $\delta$ des jonctions Josephson du composant selon le premier mode de réalisation en fonction du flux magnétique appliqué à la jonction Josephson ajustable ;
- figure 4, un schéma d'implémentation d'un composant supraconducteur « Bi-SQUID » modifié correspondant à un deuxième mode de réalisation de l'invention ;
- figure 5, un schéma électrique équivalent à un composant « Bi-SQUID » selon l'état de la technique;
- figure 6, un schéma électrique équivalent au composant « Bi-SQUID » modifié conformément à la figure 4;
- figure 7, un schéma d'implémentation d'un composant supraconducteur selon le troisième mode de réalisation de l'invention ;
- figure 8, un schéma électrique équivalent au composant selon le troisième mode de réalisation de l'invention ;
- figure 9, un schéma électrique d'implémentation d'un composant supraconducteur selon un quatrième mode de réalisation de l'invention ;
- figure 10, un schéma électrique équivalent au composant selon le quatrième mode de réalisation de l'invention ;
- figure 11, un schéma électrique équivalent à un composant supraconducteur selon un cinquième mode de réalisation de l'invention ;
- figure 12, un schéma électrique équivalent à un composant selon un sixième mode de réalisation de l'invention ;
- figure 13, un schéma d'un amplificateur comprenant des SQUID ; et
- figure 14, un schéma d'un amplificateur agencé similairement à la figure 13 avec des composants conformes à celui de la figure 1 à la place des SQUID.

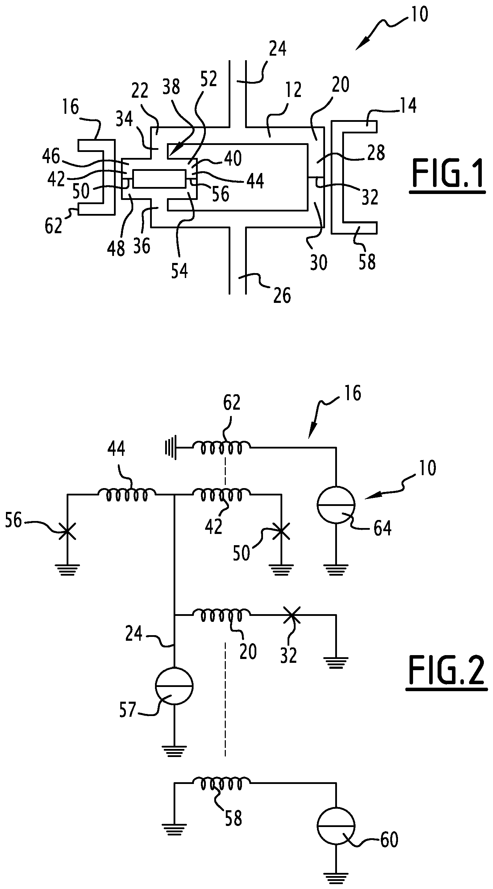

Un composant 10 supraconducteur est illustré sur la figure 1.

Le composant 10 comporte une première boucle 12 supraconductrice, un premier moyen de couplage 14 à un flux magnétique externe, un deuxième moyen de couplage 16 à un flux magnétique externe, une première branche 20, une deuxième branche 22, des accès électriques 24 et 26 sous forme d'une entrée 24 et une sortie 26 (généralement la position de l'entrée 24 et de la sortie 26 sont relatives au sens du courant électrique), les deux branches 20, 22 étant chacune reliées à une extrémité à l'entrée 24 et à l'autre extrémité à la sortie 26.

La première branche 20 comprend une première partie 28 formée dans un premier matériau supraconducteur S1, une deuxième partie 30 formée dans un deuxième matériau supraconducteur S2 et une première jonction Josephson 32 interposée entre les deux parties 28 et 30. La première partie 28 de la première branche 20 s'étend entre l'entrée 24 et la première jonction Josephson 32 tandis que la deuxième partie 30 de la première branche 20 s'étend entre la première jonction Josephson 32 et la sortie 26.

Le premier matériau supraconducteur S1 de la première partie 28 de la première branche 20 est préférablement un supraconducteur à haute température critique (>26 K), du type de ceux qui sont connus sous l'abréviation YBaCuO. En variante, à la place de l'yttrium, est utilisé du néodyme, du dysprosium, de l'europium. De préférence, le supraconducteur est non métallique, et en particulier du type céramique à base d'oxyde de cuivre (ReBaCuO, où Re représente un élément chimique du type terre rare). Ces remarques s'appliquent aussi au deuxième matériau supraconducteur S2.

Selon une variante, les deux matériaux supraconducteurs S1 et S2 sont identiques, ce qui permet de faciliter la fabrication du composant 10.

Contrairement à l'état de la technique, la deuxième branche 22 est différente de la première branche 20. Selon l'invention la deuxième branche 22 comporte une première partie 34 formée dans le premier matériau supraconducteur S1, une deuxième partie 36 formée dans le deuxième matériau supraconducteur S2 et un dispositif 38 supraconducteur à interférences quantiques noté SQUID 38 dans toute la suite de la présente description.

Le SQUID 38 est interposé entre les deux parties 34 et 36 de la deuxième branche 22. Ainsi, la première partie 34 de la deuxième branche 22 s'étend entre l'entrée 24 et le SQUID 38 tandis que la deuxième partie 36 de la deuxième branche 22 s'étend entre le SQUID 38 et la sortie 26. La branche du SQUID 38 est agencée électriquement en parallèle de la branche contenant la première jonction Josephson 32.

Le SQUID 38 comprend une deuxième boucle 40 supraconductrice comportant une première ligne 42 et une deuxième ligne 44.

La première ligne 42 comprend une première partie 46 formée dans le premier matériau supraconducteur S1, une deuxième partie 48 formée dans le deuxième matériau supraconducteur S2 et une deuxième jonction Josephson 50 interposée entre les deux parties 46, 48 de la première ligne 42. La première partie 46 de la première ligne 42 s'étend entre la première partie 34 de la deuxième branche 22 et la deuxième jonction Josephson 50 tandis que la deuxième partie 48 de la première ligne 42 s'étend entre la deuxième jonction Josephson 50 et la deuxième partie 36 de la deuxième branche 22.

La deuxième ligne 44 comprend une première partie 52 réalisée dans le premier matériau supraconducteur S1, une deuxième partie 54 réalisée dans le deuxième matériau supraconducteur S2 et une troisième jonction Josephson 56 interposée entre les deux parties 52, 54 de la deuxième ligne 44 de sorte que la troisième jonction Josephson 56 est en parallèle avec la deuxième jonction Josephson 50. La première partie 52 de la deuxième ligne 44 s'étend entre la première partie 34 de la deuxième branche 22 et la troisième jonction Josephson 56 tandis que la deuxième partie 54 de la deuxième ligne 44 s'étend entre la troisième jonction Josephson 56 et la deuxième partie 36 de la deuxième branche 22.

Le SQUID 38 sert principalement de jonction Josephson unique dont le courant critique est ajustable par un moyen « électrique » (injection de flux dans la deuxième boucle 40 supraconductrice).

En variante, d'autres éléments non linéaires dont la caractéristique courant - tension c'est-à-dire la fonction qui permet d'exprimer le courant à partir de la tension est semblable à celle d'une jonction Josephson sont utilisés à la place des jonctions Josephson 32, 50 et 56. On appelle second rapport *R2* le rapport entre le produit de l'inductance de la deuxième boucle 40 supraconductrice et du courant critique de la jonction Josephson équivalente aux deuxième jonction Josephson 50 et troisième jonction Josephson 56 et le quantum de flux $\Phi_0$. Le second rapport *R2* est compris entre 0,2 et 4, de préférence inférieur à 1. Cela se traduit mathématiquement par les relations suivantes :

$$R2 = \frac{L_2 I_{Ceq}}{\Phi_0} \leq 1$$

Où:

- *L2* est l'inductance de la deuxième boucle 40 supraconductrice, et
- $I_{Ceq}$ est le courant critique de la jonction Josephson équivalente aux deuxième jonction Josephson 50 et troisième jonction Josephson 56.

Selon l'exemple de la figure 1, par l'entrée 24 et la sortie 26, sont injectés des courants de polarisation des trois jonctions Josephson 32, 50 et 56 à l'aide d'un générateur de polarisation 57 visible sur la figure 2.

Dans le cas de la figure 1, le premier moyen de couplage 14 est sous la forme d'une première piste 58. La première piste 58 est une piste conductrice reliée à un premier générateur de courant 60 représenté sur la figure 2. La première piste 58 est en regard de la première branche 20, placée de façon à injecter efficacement un flux magnétique dans la première boucle 12.

La première piste 58 est propre à générer un premier courant *I1* dans la première boucle 12 lorsque cette première piste 58 est alimentée en courant par le premier générateur de courant 60.

La première piste 58 sert notamment à concentrer le flux magnétique dans la boucle 12.

En variante, le premier moyen de couplage 14 est une bobine.

En outre, le premier générateur de courant 60 peut être remplacé par tout autre générateur électrique (de tension ou d'une grandeur électrique intermédiaire entre courant et tension).

Selon l'exemple de la figure 1, le deuxième moyen de couplage 16 est sous la forme d'une deuxième piste 62 couplée au SQUID 38. La deuxième piste 62 est une piste conductrice reliée à un deuxième générateur de courant 64 visible sur la figure 2. La deuxième piste 62 est en regard des lignes 42 et/ou 44 de façon à injecter efficacement un flux magnétique dans la seconde boucle 40.

La deuxième piste 62 est propre à générer un deuxième courant $I2$ dans la deuxième boucle 40 lorsque cette deuxième piste 62 est alimentée en courant par le deuxième générateur de courant 64.

Le deuxième générateur de courant 64 peut être remplacé par tout autre générateur électrique (de tension ou d'une grandeur électrique intermédiaire entre courant et tension).

Selon une variante, le composant 10 est pourvu d'un seul moyen de couplage 16 pour générer un courant uniquement dans la deuxième jonction Josephson 50 et la troisième jonction Josephson 56.

Par ailleurs, pour atteindre les meilleures performances, selon une autre variante, le premier courant critique $I_{C1}$ de la première jonction Josephson 32 est supérieur à la valeur absolue de la différence entre le troisième courant critique $I_{C3}$ de la troisième jonction Josephson 56 et le deuxième courant critique $I_{C2}$ de la deuxième jonction Josephson 50 et inférieur à la somme du troisième courant critique $I_{C3}$ et du deuxième courant critique $I_{C2}$. Ces inégalités s'écrivent mathématiquement comme une inégalité triangulaire :

$$\left|I_{C3} - I_{C2}\right| \leq I_{C1} \leq I_{C2} + I_{C3}$$

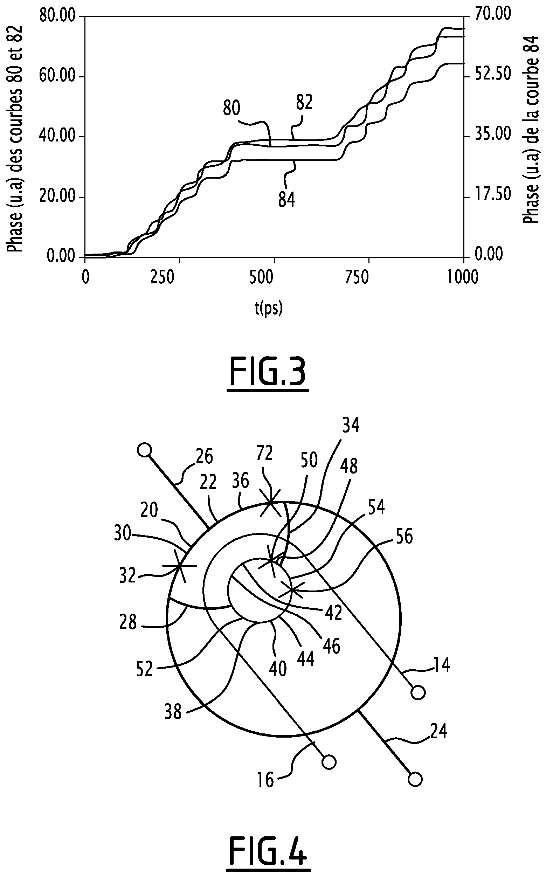

Le fonctionnement du composant 10 supraconducteur est maintenant décrit en référence à la figure 3.

Dans la simulation effectuée pour la figure 3, les valeurs de 100 μA (microampères), 60 μA et 80 μA ont respectivement été choisies pour le premier courant critique $I_{C1}$ de la première jonction Josephson 32, le deuxième courant critique $I_{C2}$ de la deuxième jonction Josephson 50 et le troisième courant critique $I_{C3}$ de la troisième jonction Josephson 56. Lorsque la deuxième piste 60 est alimentée par un courant augmentant de 0 à 400 μA, un flux magnétique proportionnel au temps est généré dans le SQUID 38. Ainsi, en représentant l'évolution temporelle de la phase $\delta$ de la première Jonction Josephson 32 (courbe 80), de la deuxième jonction Josephson 50 (courbe 82) et de la troisième jonction Josephson 56 (courbe 84), il est observé le passage d'un état statique (les trois phases sont constantes) à un état dynamique (évolution monotone des phases pour chacune des jonctions Josephson).

Lorsque le flux magnétique créé par la deuxième piste 60 est proche d'un multiple du quantum de flux $\Phi_0$, le courant critique $I_{Ceq}$ de la jonction Josephson équivalente au SQUID 38 est maximum. Le courant critique $I_{C10}$ du composant 10 qui correspond au courant critique équivalent au SQUID 38 et à la première jonction Josephson est alors maximal. Le courant de polarisation injecté via l'entrée 24 et la sortie 26 du composant 10 est plus faible que le courant critique $I_{C10}$ du composant 10, de sorte que les trois jonctions Josephson 32, 50 et 56 sont toutes dans un état statique, c'est-à-dire un état dans lequel la différence de potentiel de part et d'autre des jonctions Josephson 32, 50 et 56 est nulle. Dans le cas de la simulation présentée figure 3, cet effet s'observe sur les plages de temps comprises entre 0 et 100 picosecondes (ps) et entre 400 ps et 650 ps.

Par contre, pour les plages de temps comprises entre 100 ps à 400 ps et entre 650 ps à 900 ps, le courant critique $I_{Ceq}$ de la jonction Josephson équivalente au SQUID 38 (de même que pour des résistances en parallèle, il peut être défini une jonction Josephson équivalente à deux jonctions Josephson en parallèle comme dans le cas du SQUID 38) est réduit. Le courant critique $I_{C10}$ du composant 10 est alors réduit. Le courant de polarisation injecté via l'entrée 24 et la sortie 26 du composant 10 est alors plus fort que le courant critique $I_{C10}$ du composant 10, de sorte que les trois jonctions Josephson 32, 50 et 56 sont toutes dans un état dynamique, c'est-à-dire un état dans lequel la phase de la jonction Josephson évolue de façon monotone avec le temps.

Ainsi, grâce au courant alimentant la deuxième piste 62, il est possible de régler le courant critique $I_{Ceq}$ de la jonction Josephson équivalente au SQUID 38. De ce fait, le composant 10 supraconducteur se comporte comme un SQUID dont le courant critique peut être réduit jusqu'à zéro par un flux magnétique de contrôle, par exemple introduit par la deuxième piste 62.

Par rapport au SQUID à courant continu, le remplacement d'une des deux jonctions Josephson par le SQUID 38 dont la caractéristique courant - tension est ajustable permet d'obtenir un composant 10 ayant une amplitude de modulation maximale lorsque les courants critiques de la première jonction Josephson 32 et le courant critique du SQUID 38 sont égaux. Un tel composant 10 permet d'obtenir une réponse mieux contrôlée ayant notamment des applications pour des circuits amplificateurs. Plus généralement, cette propriété est utile pour toutes les applications où un très bon appariement des jonctions Josephson est souhaitable.

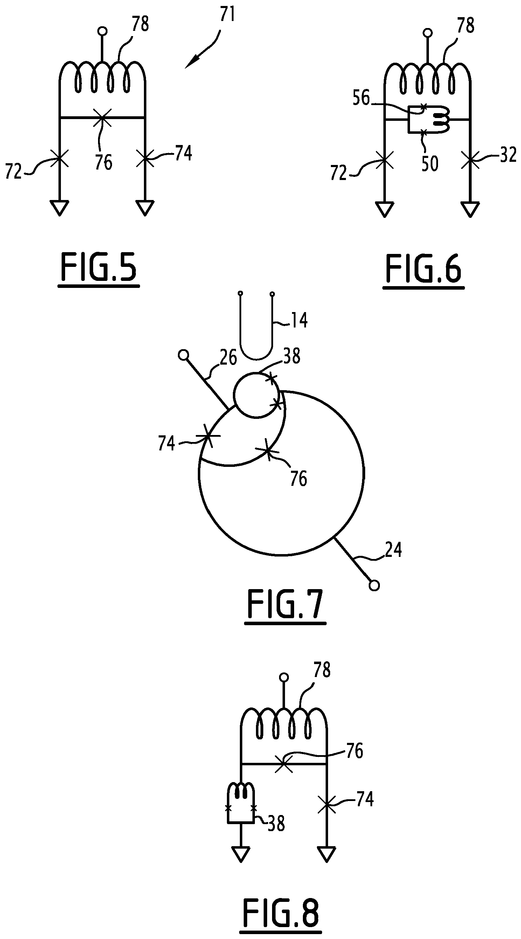

Selon un autre mode de réalisation tel que représenté à la figure 7, le composant 10 supraconducteur comprend les mêmes éléments que le composant 10 selon le premier mode de réalisation. Seules les différences sont mises en évidence. Une quatrième jonction Josephson 76 est ajoutée en parallèle avec la mise en série de la première partie 28 de la première branche 20 et la première partie 34 de la deuxième branche 22.

Ce montage est particulièrement avantageux puisqu'il combine les avantages de la présente invention avec ceux du circuit dit « Bi-SQUID » tel que représenté figure 5 et décrit dans les références US-B-8 179 133 et dans la publication de Kornev et al. intitulée « DC SQUID array with nonlinear inductance » issue du Journal of Physics : Conférence Series 234 (2010) 042034. Le contenu de ces documents est inséré par référence dans ce brevet. Un circuit Bi-SQUID est un circuit 71 tel que représenté à la figure 5. Il comporte trois jonctions Josephson 72, 74, 76 en série, les jonctions 72 et 74 constituant avec l'inductance de boucle 78 un composant SQUID ; la jonction Josephson 76 du milieu étant en parallèle avec l'inductance de boucle 78 constitue un deuxième SQUID (d'où l'appellation Bi-SQUID). Cela permet d'améliorer la linéarité du composant 10. Dans un mode de réalisation préféré, l'inductance de boucle 78 est principalement l'inductance formée par la première partie 28 de la première branche 20 et la première partie 34 de la deuxième branche 22 ; l'inductance formée par la deuxième partie 30 de la première branche 20 et la deuxième partie 36 de la deuxième branche 22 étant réduite par exemple en réduisant leurs longueurs.

Il peut être montré que la linéarité du circuit 71 de la figure 5 dépend fortement de la valeur du courant critique de la jonction Josephson 76. Même si le composant décrit figure 7 offre l'avantage d'une possibilité de contrôle du courant critique, il est envisageable de le modifier en utilisant un ou plusieurs SQUID 38 pour régler le courant critique dans l'une quelconque des branches 20, 22 ou de la branche en parallèle obtenue avec la mise en série des conducteurs de la première partie 28 de la première branche 20 et la première partie 34 de la deuxième branche 22) comme illustré par les figures 4, 6, 7, 8, 9, 10, 11, 12.

La figure 4 montre cette modification pour que le contrôle du courant critique porte sur l'élément en parallèle avec l'inductance de boucle 78; cette figure illustre également une possibilité de réalisation du circuit de commande du SQUID 38 sous forme d'une fourche positionnée à l'aplomb du SQUID 38, tout en ayant un faible coefficient de couplage avec les autres parties du circuit.

Lorsque le circuit électrique correspondant au mode de réalisation de la figure 4 est tracé comme le montre la figure 6, il apparaît qu'appliquer l'idée de la jonction Josephson à courant critique contrôlable revient à remplacer la jonction Josephson 76 du milieu par le SQUID 38. Avec la substitution effectuée, le courant critique est ajustable et ainsi, une bonne linéarité pour le composant est obtenue.

Bien entendu, ainsi que l'illustrent les figures 7 à 12, pour améliorer la linéarité du circuit BI-SQUID 71 en utilisant le principe de l'invention, d'autres configurations sont possibles puisque les courants critiques des différentes jonctions Josephson 72, 74, 76 sont simplement à ajuster les uns relativement aux autres.

Par exemple, comme le montrent les figures 7 et 8, il est également possible au lieu de remplacer la jonction Josephson 76 du milieu par le SQUID 38 de remplacer l'une des deux autres jonctions Josephson 72, 74 par le SQUID 38. Cette variante présente, en outre, l'avantage d'être simple à implémenter.

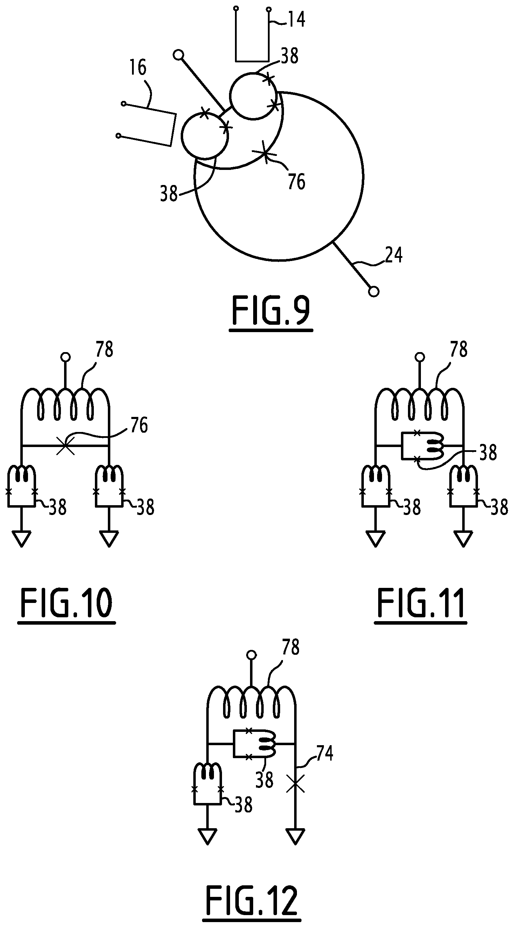

Selon un autre mode de réalisation présenté aux figures 9 et 10, il est aussi possible, au lieu de remplacer la jonction Josephson du milieu 76 par le SQUID 38, de remplacer les deux autres jonctions Josephson 72, 74 respectivement par un SQUID 38. Cette variante présente, en outre, l'avantage d'être simple à implémenter.

Selon un autre mode de réalisation illustré par la figure 11, les trois jonctions Josephson 72, 74, 76 sont remplacées chacune par un SQUID 38.

Selon encore un autre mode de réalisation qu'illustre la figure 12, la jonction Josephson du milieu 76 et une autre jonction Josephson 72, 74 sont chacune remplacées par un SQUID 38.

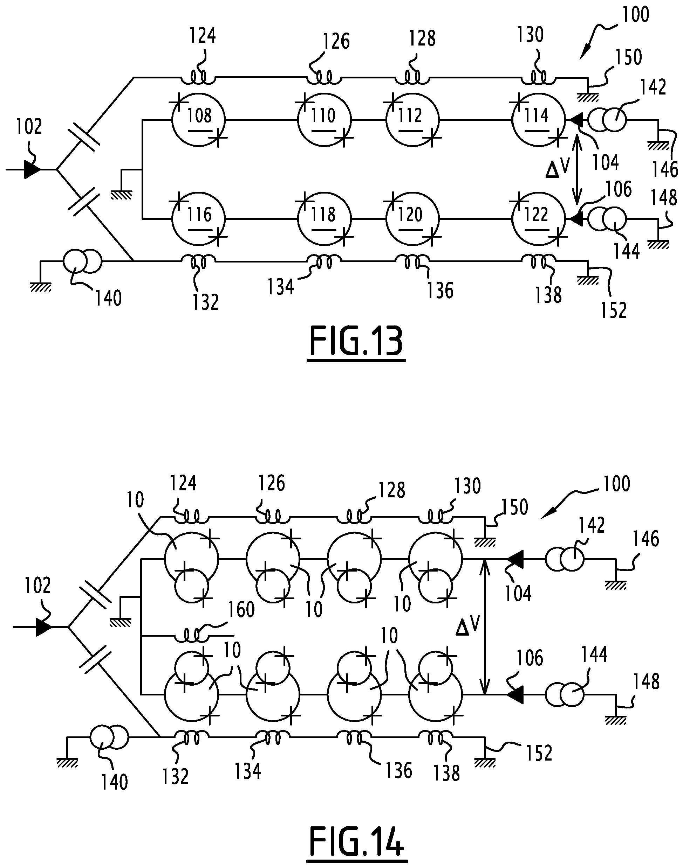

La figure 14 présente une application particulière du composant 10 supraconducteur.

Le composant 10 supraconducteur est, par exemple, utilisé dans un amplificateur 100 tel que présenté à la figure 13. L'amplificateur 100 de la figure 13 est dépourvu de composant 10 pour illustrer son agencement et son fonctionnement en l'absence du composant 10.

L'amplificateur 100 comporte une entrée 102, deux sorties 104, 106, huit SQUID 108, 110, 112, 114, 116, 118, 120 et 122, huit inductances 124, 126, 128, 130, 132, 134, 136 et 138 positionnées respectivement en regard d'un des huit SQUID 108, 110, 112, 114, 116, 118, 120 et 122, une alimentation 140 des inductances et deux générateurs de polarisation 142, 144 des huit SQUID 108, 110, 112, 114, 116, 118, 120 et 122. Par souci de simplification, le circuit générant les polarisations en flux opposées, est ici représenté schématiquement, commun avec le circuit de couplage du signal d'entrée, mais ceci n'est qu'une possibilité, d'autres modes de réalisations étant envisageables.

La différence de potentiel $\Delta V$ entre les deux sorties 104 et 106 correspond à une amplification du signal envoyé à l'entrée 102.

Les SQUID 108, 110, 112, 114, 116, 118, 120 et 122, sont agencés selon deux lignes 146, 148 qui sont reliées respectivement aux deux générateurs de polarisation 142 et 144 ainsi qu'aux deux sorties 104 et 106. Les premier, deuxième, troisième et quatrième SQUID 108, 110, 112 et 114, de la gauche vers la droite sur la figure 13, sont agencés en série le long de la première ligne 146. Les cinquième, sixième, septième et huitième SQUID 116, 118, 120 et 122, de la gauche vers la droite sur la figure 13, sont agencés en série le long de la deuxième ligne 148.

Pour la clarté de l'exposé, chaque SQUID 108, 110, 112, 114, 116, 118, 120 et 122 est monté selon une paire en différentiel (ou « doublet »), c'est-à-dire que chaque SQUID de la première ligne 146 est en regard d'un SQUID respectif de la deuxième ligne 148. Plus précisément, le premier SQUID 108 est en regard du cinquième SQUID 116, le deuxième SQUID 110 est en regard du sixième SQUID 118, le troisième SQUID 112 est en regard du septième SQUID 120 et le quatrième SQUID 114 est en regard du huitième SQUID 122. Cette configuration n'est pas indispensable au fonctionnement de l'amplificateur 100.

De même que les SQUID, les huit inductances 124, 126, 128, 130, 132, 134, 136 et 138 sont agencées en série selon deux lignes, à savoir une troisième ligne 150 et une quatrième ligne 152. Les troisième et quatrième lignes 150, 152 sont reliées à l'entrée 102. La troisième ligne 150 est reliée à une alimentation des inductances pour injecter un flux proche de $\Phi_0/4$ et la quatrième ligne 152 est reliée à l'alimentation 140 des inductances pour injecter un flux proche de $-\Phi_0/4$ ($\Phi_0$ est le quantum de flux).

Chacun des SQUID 108, 110, 112, 114, présente le même courant critique noté $I_k$ que respectivement les SQUID 116, 118, 120 et 122. Le courant critique d'un SQUID est la somme des courants critiques des deux jonctions Josephson du SQUID.

Les première, deuxième, troisième et quatrième inductances 124, 126, 128 et 130, de la gauche vers la droite sur la figure 13, sont agencées le long de la troisième ligne 150. Les cinquième, sixième, septième et huitième inductances 132, 134, 136 et 138, de la gauche vers la droite sur la figure 13, sont agencées le long de la quatrième ligne 152.

L'alimentation 140 des inductances est propre à faire générer aux inductances de la troisième ligne 150 un flux de polarité opposée à celui généré par les inductances de la quatrième ligne 152.

Chacun des générateurs de polarisation 142, 144 est propre à polariser chacun des huit SQUID 108, 110, 112, 114, 116, 118, 120 et 122 avec un courant de polarisation noté $I_0$.

Il est à noter que l'illustration de la figure 13 montre huit SQUID (quatre « doublets »), mais bien entendu, l'amplificateur 100 pourrait comporter un nombre de doublets quelconque. De même pour les inductances schématisant un couplage magnétique entre le circuit d'entrée du signal et chacun des « doublets ».

Le fonctionnement de l'amplificateur 100 est maintenant décrit.

Le fonctionnement de l'amplificateur 100 repose sur l'addition de réponses de plusieurs SQUID (périodiques), pour obtenir une fonction de transfert linéaire, donc triangulaire, ou tout autre fonction présentant une pente régulière (autrement formulé approximativement constante) sur une plage comparable à l'excursion du signal. Par exemple, la fonction de transfert est une montée linéaire entre $-\pi/2$ et $\pi/2$ suivie d'une descente sinusoïdale entre $\pi/2$ et $3\pi/2$.

Un signal approchant d'un tel signal triangulaire est obtenu avec une paire de SQUID monté en différentiel (doublet) comme illustré sur la figure 13.

En effet, considérons la première paire de SQUID après l'entrée 102. Cette première paire de SQUID comprend le premier SQUID 108 et le cinquième SQUID 116. Ces deux SQUID 108 et 116 présentent le même courant critique $I_k$ et sont polarisés par le courant de polarisation $I_0$. En outre, l'alimentation des inductances 140 impose un flux magnétique au cinquième SQUID 116 décalé de $\Phi_0/4$ par rapport au flux magnétique imposé au premier SQUID 108. La différence de potentiel entre les deux SQUID 108, 116 est donnée par :

$$\delta V = V_5 - V_1 = V_{C5}\sqrt{i_k^2 - \cos^2\left(\pi\frac{\Phi_5}{\Phi_0}\right)} - V_{C1}\sqrt{i_k^2 - \cos^2\left(\pi\frac{\Phi_1}{\Phi_0}\right)}$$

Où:

- $\delta V$ est la différence de potentiel entre les deux SQUID 108, 116,
- $V_1$ est le potentiel du premier SQUID 108,
- $V_5$ est le potentiel du cinquième SQUID 116,
- $V_{C1} = R_1.I_k$ est la tension caractéristique du premier SQUID 108,
- $V_{C5} = R_5.I_k$ est la tension caractéristique du cinquième SQUID 116,
- $i_k = I_0/2I_k$ est le courant de polarisation normalisé au courant critique du SQUID,
- $\Phi_1 = \Phi + \Phi_0/4$ est le flux total appliqué au premier SQUID 108, $\Phi$ étant le flux lié au signal en entrée et
- $\Phi_5 = \Phi - \Phi_0/4$ est le flux total appliqué au cinquième SQUID 116, $\Phi$ étant le flux lié au signal en entrée.

Notons que le décalage de $\Phi_0/4$ n'est pas critique. Il s'agit d'un compromis entre grand gain et grande excursion du signal. Pour $i_k = 1$ et $R_1 = R_5$, on peut écrire $\delta V$ sous la forme :

$$\delta V \;=\; \sqrt{2}.R_1 I_k .\sin (x)$$

Où $x = \dfrac{\pi}{\Phi_0} \Phi$ est une variable proportionnelle au flux créé par le signal. Idéalement, cette configuration offre l'avantage de supprimer toutes les harmoniques paires dans la réponse du circuit.

On a imposé notamment que le courant de polarisation $I_0$ soit égal au courant critique $I_k$ des premier et cinquième SQUID 108, 116 pour que cette tension $\delta V$ soit proche d'une réponse triangulaire.

Cette condition $I_0 = I_k$ est assez difficile à satisfaire, voire impossible si les caractéristiques courant-tension des SQUID 108, 116 de la paire ont la moindre dispersion. Les courants de polarisation permettent de compenser en partie cette dispersion. Ainsi, il est possible d'équilibrer les courants de polarisations appliqués de façon à éliminer l'harmonique 2 en sortie de l'amplificateur 100. Si les produits $R_1.I_k$ et $R_5.I_k$ sont égaux, toutes les harmoniques paires peuvent être éliminées simultanément.

Pour encore améliorer la forme triangulaire, il est possible d'utiliser d'autres paires de SQUID (trois sont représentés à titre d'exemple sur la figure 13 mais tout autre nombre serait envisageable), qui permettent de contrôler les harmoniques. Il est aussi envisageable d'utiliser des réseaux de SQUIDs en parallèle.

A l'étude de ce mode fonctionnement de l'amplificateur 100 de la figure 13, il apparaît que même avec des dispersions de l'ordre du pourcent, il est souhaitable de disposer de moyens de compensation des dispersions des caractéristiques courant-tension des SQUID 108, 110, 112, 114, 116, 118, 120 et 122 pour linéariser au mieux le fonctionnement de l'amplificateur 100.

C'est pourquoi il est proposé à la figure 14 une architecture d'amplificateur 100 similaire à celle de la figure 13 dans laquelle des composants 10 conformes à celui représenté sur la figure 1 remplacent les SQUID.

En outre, l'amplificateur 100 comprend, pour chaque composant 10, un moyen de contrôle 160 du courant critique de ce composant 10.

Pour simplifier la figure 5, seul un moyen de contrôle 160 du courant critique dans le composant 10 est représenté. Le moyen 160 de contrôle du courant critique dans le composant 10 est un moyen de génération d'un flux magnétique. Plus précisément, le moyen 160 de contrôle du courant critique dans le composant 10 est une inductance reliée à un générateur délivrant un courant noté $I_{contrôle}$, l'inductance étant placée à proximité du composant 10.

L'intérêt d'utiliser un composant 10 supraconducteur tel que proposé à la figure 1 pour l'amplificateur 100 est expliqué en exposant le fonctionnement de l'amplificateur 100 de la figure 14.

Comme expliqué précédemment, le composant 10 supraconducteur se comporte comme un SQUID dont le courant critique de l'une des jonctions Josephson est contrôlable par un flux magnétique de contrôle. Appliqué à la première paire de composants 10 montés en différentiel, cela permet ainsi d'équilibrer les produits $R_n*I_n$ (l'indice $n$ désigne le numéro du composant 10 considéré) de la première paire de l'amplificateur 100 par simple modification du flux magnétique de contrôle appliqué. Cet équilibrage annule les harmoniques paires de la réponse de l'amplificateur 100. Il est à noter que cette annulation se produit même si les caractéristiques des différents composants 10 de l'amplificateur 100 présentent une dispersion.

Ce principe appliqué à l'harmonique 2 peut s'appliquer ensuite à la deuxième paire de composants pour l'harmonique d'ordre 3.

De proche en proche, il est ainsi possible d'obtenir une réponse avec linéarité améliorée pour l'amplificateur 100.

Ainsi, l'amplificateur 100 présente des propriétés améliorées en termes de distorsion harmonique. Plus précisément, l'amplificateur 100, de par sa technologie, dissipe très peu de puissance, a un bruit extrêmement faible et une très grande bande passante. L'emploi du composant 10 supraconducteur proposé à la figure 1 permet de réduire la distorsion harmonique de l'amplificateur 100 à un très faible niveau. Selon une variante, un des deux composants 10 est un SQUID à courant continu.

**Revendications**

1. Composant (10) supraconducteur comprenant une première boucle (12) supraconductrice, la première boucle (12) supraconductrice comportant :

   • une première branche (20) comprenant une première jonction Josephson (32),
   • une deuxième branche (22),

   la deuxième branche (22) comprenant un premier dispositif supraconducteur à interférence quantique (38) à courant continu,

le premier dispositif supraconducteur à interférence quantique (38) à courant continu comportant une deuxième jonction Josephson (50) et une troisième jonction Josephson (56), un courant critique ($I_{C1}$, $I_{C2}$, $I_{C3}$) étant défini pour chaque jonction Josephson (32, 50, 56), le courant critique ($I_{C1}$) de la première jonction Josephson (32) est supérieur à la valeur absolue de la différence entre le courant critique ($I_{C3}$) de la troisième jonction Josephson (56) et le courant critique ($I_{C2}$) de la deuxième jonction Josephson (50) et inférieur à la somme du courant critique ($I_{C2}$) de la deuxième jonction Josephson (50) et du courant critique ($I_{C3}$) de la troisième jonction Josephson (56), **caractérisé en ce que** le composant (10) comprend des moyens de génération de flux magnétique (14, 16, 58, 60, 62 64) sous forme de pistes conductrices (58,62) positionnées au regard des branches (20, 22), une piste (58,62) étant couplée au premier dispositif supraconducteur à interférence quantique (38), les moyens de génération de flux magnétique (14,16,58,60,62,64) étant agencés de façon à injecter efficacement un flux magnétique dans le premier dispositif supraconducteur à interférence quantique (38) à courant continu.

2. Composant selon la revendication 1 comprenant en outre une quatrième jonction Josephson (76) en parallèle avec une partie (28) de la première branche (20) et une partie (34) de la deuxième branche (22), les deux parties (28, 34) formant une inductance de boucle (78) en parallèle de la quatrième jonction Josephson (76).

3. Composant selon la revendication 1 ou 2, dans lequel la deuxième branche (22) comprend le premier dispositif supraconducteur à interférence quantique (38) à courant continu, monté en parallèle avec une inductance de boucle (78) formée par une partie (28) de la première branche (20) et une partie (34) de la deuxième branche (22), l'ensemble étant monté en série avec une quatrième jonction Josephson (72) dont le courant critique est égal au courant critique de la première jonction Josephson (32) à 1% près.

4. Composant selon la revendication 2 ou 3 comprenant, en outre une cinquième jonction Josephson agencée pour que la première jonction Josephson (32) et la cinquième jonction Josephson forment un deuxième dispositif supraconducteur à interférence quantique à courant continu distinct du premier dispositif supraconducteur à interférence quantique (38) à courant continu.

5. Composant selon la revendication 3 comprenant en outre :

   - une cinquième jonction Josephson agencée pour que la première jonction (32) Josephson et la cinquième jonction Josephson forment un deuxième dispositif supraconducteur à interférence quantique à courant continu distinct du premier dispositif supraconducteur à interférence quantique (38) à courant continu, et
   - une sixième jonction Josephson agencée pour que la quatrième jonction Josephson et la sixième jonction Josephson forment un troisième dispositif supraconducteur à interférence quantique à courant continu distinct du premier dispositif supraconducteur à interférence quantique (38) à courant continu et du deuxième dispositif supraconducteur à interférence quantique.

6. Composant selon l'une quelconque des revendications 1 à 5, dans lequel, en définissant un second rapport (R2), dont :

   • le numérateur est le produit de l'inductance de la deuxième boucle (40) et du courant critique de la jonction équivalente au premier dispositif supraconducteur à interférence quantique (38) à courant continu et
   • le dénominateur est le quantum de flux, défini comme le rapport de la constante de Planck sur la charge électrique d'une paire de Cooper,

   le second rapport (R2) est compris entre 0,2 et 4, de préférence inférieur à 1.

7. Amplificateur (100) comprenant :

   • une entrée (102),
   • deux sorties (104, 106), la différence de potentiel entre les deux sorties (104, 106) correspondant à une amplification d'un signal imposé en entrée de l'amplificateur (100),
   • deux premiers éléments supraconducteurs à interférence quantique (10, 108, 110, 112, 114, 116, 118, 120, 122), dits premier doublet, montés en différentiel et reliés chacun à une respective des sorties (104, 106) de l'amplificateur (100), les deux éléments supraconducteurs à interférence quantique du premier doublet (10, 108, 110, 112, 114, 116, 118, 120, 122) étant choisis parmi :

      - un composant (10) selon l'une quelconque des revendications 1 à 8 et un dispositif supraconducteur à interférence quantique (108, 110, 112, 114, 116, 118, 120, 122) à courant continu, ou
- deux composants (10) selon l'une quelconque des revendications 1 à 6, et

• un moyen (160) de contrôle de la différence de flux magnétique appliqué aux deux éléments supraconducteurs à interférence quantique du premier doublet (10, 108, 110, 112, 114, 116, 118, 120, 122).

8. Amplificateur selon la revendication 7, dans lequel sont interposés entre les deux premiers doublets (10, 108, 110, 112, 114, 116, 118, 120, 122) et les deux sorties:

• au moins deux deuxièmes doublets comprenant deux éléments supraconducteurs à interférence quantique (10, 108, 110, 112, 114, 116, 118, 120, 122) montés en différentiel, et reliés chacun à une respective des sorties (104, 106) de l'amplificateur (100), les deux éléments supraconducteurs à interférence quantique de chaque deuxième doublet (10, 108, 110, 112, 114, 116, 118, 120, 122) étant choisis parmi :

- un composant (10) selon l'une quelconque des revendications 1 à 8 et un dispositif supraconducteur à interférence quantique (108, 110, 112, 114, 116, 118, 120, 122) à courant continu, ou
- deux composants (10) selon l'une quelconque des revendications 1 à 6, et

• un moyen (160) de contrôle de la différence de flux magnétique appliqué aux deux éléments supraconducteurs à interférence quantique (10, 108, 110, 112, 114, 116, 118, 120, 122) de chaque deuxième doublet.

## Patentansprüche

1. Supraleiter-Komponente (10), welche eine erste supraleitende Schleife (12) aufweist, wobei die erste supraleitende Schleife (12) aufweist:

• einen ersten Zweig (20), welcher einen ersten Josephson-Kontakt (32) aufweist,
• einen zweiten Zweig (22),

wobei der zweite Zweig (22) eine erste Supraleiter-Vorrichtung für Quanteninterferenz (38) mit Gleichstrom aufweist, wobei die erste Supraleiter-Vorrichtung für Quanteninterferenz (38) mit Gleichstrom einen zweiten Josephson-Kontakt (50) und einen dritten Josephson-Kontakt (56) aufweist, wobei ein kritischer Strom ($I_{C1}$, $I_{C2}$, $I_{C3}$) für jeden Josephson-Kontakt (32, 50, 56) definiert ist, wobei der kritische Strom ($I_{C1}$) des ersten Josephson-Kontakts (32) größer ist als der Absolutwert der Differenz zwischen dem kritischen Strom ($I_{C3}$) des dritten Josephson-Kontakts (56) und dem kritischen Strom ($I_{C2}$) des zweiten Josephson-Kontakts (50) und kleiner als die Summe des kritischen Stroms ($I_{C2}$) des zweiten Josephson-Kontakts (50) und des kritischen Stroms ($I_{C3}$) des dritten Josephson-Kontakts (56), **dadurch gekennzeichnet, dass**
die Komponente (10) Mittel zum Erzeugen von magnetischem Fluss (14, 16, 58, 60, 62 64) in Form von Leiterbahnen (58, 62) aufweist, die gegenüber den Zweigen (20, 22) angeordnet sind, wobei eine Bahn (58, 62) mit der ersten Supraleiter-Vorrichtung für Quanteninterferenz (38) gekoppelt ist, wobei die Mittel zum Erzeugen von magnetischem Fluss (14, 16, 58, 60, 62, 64) eingerichtet sind, um effizient einen magnetischen Fluss in die erste Supraleiter-Vorrichtung für Quanteninterferenz (38) mit Gleichstrom zu injizieren.

2. Komponente gemäß Anspruch 1, welche ferner einen vierten Josephson-Kontakt (76) parallel zu einem Abschnitt (28) des ersten Zweigs (20) und einem Abschnitt (34) des zweiten Zweigs (22) aufweist, wobei die beiden Abschnitte (28, 34) eine Schleife-Induktivität (78) parallel zu dem vierten Josephson-Kontakt (76) bilden.

3. Komponente gemäß Anspruch 1 oder 2, wobei der zweite Zweig (22) die erste Supraleiter-Vorrichtung für Quanteninterferenz (38) mit Gleichstrom aufweist, die parallel zu einer Schleife-Induktivität (78) montiert ist, welche mittels eines Abschnitts (28) des ersten Zweigs (20) und eines Abschnitts (34) des zweiten Zweigs (22) gebildet ist, wobei die Anordnung in Reihe mit einem vierten Josephson-Kontakt (72) montiert ist, dessen kritischer Strom bis auf 1% gleich dem kritischen Strom des ersten Josephson-Kontakts (32) ist.

4. Komponente gemäß Anspruch 2 oder 3, welche ferner einen fünften Josephson-Kontakt aufweist, der eingerichtet ist, damit der erste Josephson-Kontakt (32) und der fünfte Josephson-Kontakt eine zweite Supraleiter-Vorrichtung für Quanteninterferenz mit Gleichstrom bilden, welche von der ersten Supraleiter-Vorrichtung für Quanteninterferenz (38) mit Gleichstrom verschieden ist.

**5.** Komponente gemäß Anspruch 3, welche ferner aufweist:

- einen fünften Josephson-Kontakt, der eingerichtet ist, damit der erste Josephson-Kontakt (32) und der fünfte Josephson-Kontakt eine zweite Supraleiter-Vorrichtung für Quanteninterferenz mit Gleichstrom bilden, welche von der ersten Supraleiter-Vorrichtung für Quanteninterferenz (38) mit Gleichstrom verschieden ist, und
- einen sechsten Josephson-Kontakt, der eingerichtet ist, damit der vierte Josephson-Kontakt und der sechste Josephson-Kontakt eine dritte Supraleiter-Vorrichtung für Quanteninterferenz mit Gleichstrom bilden, welche von der ersten Supraleiter-Vorrichtung für Quanteninterferenz (38) mit Gleichstrom und von der zweiten Supraleiter-Vorrichtung für Quanteninterferenz verschieden ist.

**6.** Komponente gemäß irgendeinem der Ansprüche 1 bis 5, wobei, beim Definieren eines zweiten Quotienten (R2), von welchem:

• der Zähler das Produkt der Induktivität der zweiten Schleife (40) und des kritischen Stroms des Kontakts ist, der äquivalent zur ersten Supraleiter-Vorrichtung für Quanteninterferenz (38) mit Gleichstrom ist, und
• der Nenner das Flussquantum ist, welches als das Verhältnis der Planck-Konstante über der elektrischen Ladung eines Cooper-Paares definiert ist,

der zweite Quotient (R2) zwischen 0,2 und 4 enthalten, vorzugsweise kleiner als 1, ist.

**7.** Verstärker (100), welcher aufweist:

• einen Eingang (102),
• zwei Ausgänge (104, 106), wobei die Potenzialdifferenz zwischen den beiden Ausgängen (104, 106) zu einer Verstärkung eines Signals, welches am Eingang des Verstärkers (100) angelegt ist, korrespondiert,
• zwei erste Supraleiter-Elemente für Quanteninterferenz (10, 108, 110, 112, 114, 116, 118, 120, 122), erstes Dublett genannt, die differentiell montiert und jeweilig mit einem jeweiligen der Ausgänge (104, 106) des Verstärkers (100) verbunden sind, wobei die beiden Supraleiter-Elemente für Quanteninterferenz des ersten Dubletts (10, 108, 110, 112, 114, 116, 118, 120, 122) ausgewählt sind aus:

- einer Komponente (10) gemäß irgendeinem der Ansprüche 1 bis 8 und einer Supraleiter-Vorrichtung für Quanteninterferenz (108, 110, 112, 114, 116, 118, 120, 122) mit Gleichstrom oder
- zwei Komponenten (10) gemäß irgendeinem der Ansprüche 1 bis 6 und

• einem Mittel (160) zum Steuern der Differenz des magnetischen Flusses, der an die beiden Supraleiter-Elemente für Quanteninterferenz des ersten Dubletts (10, 108, 110, 112, 114, 116, 118, 120, 122) angelegt ist.

**8.** Verstärker gemäß Anspruch 7, wobei zwischen den beiden ersten Dubletts (10, 108, 110, 112, 114, 116, 118, 120, 122) und den beiden Ausgängen zwischengeschaltet sind:

• mindestens zwei zweite Dubletts, welche zwei Supraleiter-Elemente für Quanteninterferenz (10, 108, 110, 112, 114, 116, 118, 120, 122) aufweisen, die differentiell montiert und jeweilig mit einem jeweiligen der Ausgänge (104, 106) des Verstärkers (100) verbunden sind, wobei die beiden Supraleiter-Elemente für Quanteninterferenz von jedem zweiten Dublett (10, 108, 110, 112, 114, 116, 118, 120, 122) ausgewählt sind aus:

- einer Komponente (10) gemäß irgendeinem der Ansprüche 1 bis 8 und einer Supraleiter-Vorrichtung für Quanteninterferenz (108, 110, 112, 114, 116, 118, 120, 122) mit Gleichstrom oder
- zwei Komponenten (10) gemäß irgendeinem der Ansprüche 1 bis 6 und

• einem Mittel (160) zum Steuern der Differenz des magnetischen Flusses, der an die beiden Supraleiter-Elemente für Quanteninterferenz (10, 108, 110, 112, 114, 116, 118, 120, 122) von jedem zweiten Dublett angelegt ist.

**Claims**

**1.** Superconducting component (10) comprising a first superconducting loop (12), the first superconducting loop (12) comprising:

• a first branch (20) comprising a first Josephson junction (32),
• a second branch (22),

the second branch (22) comprising a first direct-current superconducting quantum interference device (38),
the first direct-current superconducting quantum interference device (38) comprising a second Josephson junction (50) and a third Josephson junction (56), a critical current ($I_{C1}$, $I_{C2}$, $I_{C3}$) being defined for each Josephson junction (32, 50, 56), the critical current ($I_{C1}$) of the first Josephson junction (32) is greater than the absolute value of the difference between the critical current ($I_{C3}$) of the third Josephson junction (56) and the critical current ($I_{C2}$) of the second Josephson junction (50) and less than the sum of the critical current ($I_{C2}$) of the second Josephson junction (50) and the critical current ($I_{C3}$) of the third Josephson junction (56), **characterised in that** the component (10) comprises magnetic flux generating means (14, 16, 58, 60, 62, 64) in the form of conductive tracks (58, 62) positioned opposite the branches (20, 22), one track (58, 62) being coupled to the first superconducting quantum interference device (38), the magnetic flux generating means (14, 16, 58, 60, 62, 64) being arranged so as to efficiently inject a magnetic flux into the first direct-current superconducting quantum interference device (38).

2. Component according to claim 1, further comprising a fourth Josephson junction (76) in parallel with a portion (28) of the first branch (20) and a portion (34) of the second branch (22), the two portions (28, 34) forming a loop inductor (78) in parallel with the fourth Josephson junction (76).

3. Component according to claim 1 or 2, wherein the second branch (22) comprises the first direct-current superconducting quantum interference device (38), mounted in parallel with a loop inductor (78) formed by a portion (28) of the first branch (20) and a portion (34) of the second branch (22), the assembly being mounted in series with a fourth Josephson junction (72), the critical current of which is equal to the critical current of the first Josephson junction (32), to within 1%.

4. Component according to claim 2 or 3, further comprising a fifth Josephson junction arranged so that the first Josephson junction (32) and the fifth Josephson junction form a second direct-current superconducting quantum interference device distinct from the first direct-current superconducting quantum interference device (38).

5. Component according to claim 3, further comprising:

   - a fifth Josephson junction arranged so that the first Josephson junction (32) and the fifth Josephson junction form a second direct-current superconducting quantum interference device distinct from the first direct-current superconducting quantum interference device (38), and
   - a sixth Josephson junction arranged so that the fourth Josephson junction and the sixth Josephson junction form a third direct-current superconducting quantum interference device distinct from the first direct-current superconducting quantum interference device (38) and from the second superconducting quantum interference device.

6. Component according to any one of claims 1 to 5, wherein, in defining a second ratio (R2), in which:

   • the numerator is the product of the inductance of the second loop (40) and the critical current of the junction equivalent to the first direct-current superconducting quantum interference device (38), and
   • the denominator is the flux quantum, defined as the ratio of the Planck constant to the electric charge of a Cooper pair,

   the second ratio (R2) is between 0.2 and 4, preferably less than 1.

7. Amplifier (100) comprising:

   • an input (102),
   • two outputs (104, 106), the potential difference between the two outputs (104, 106) corresponding to an amplification of a signal imposed at the input of the amplifier (100),
   • two first superconducting quantum interference elements (10, 108, 110, 112, 114, 116, 118, 120, 122), called the first doublet, mounted differentially and each connected to a respective one of the outputs (104, 106) of the amplifier (100), the two superconducting quantum interference elements of the first doublet (10, 108, 110, 112, 114, 116, 118, 120, 122) being chosen from:

- a component (10) according to any one of claims 1 to 8 and a direct-current superconducting quantum interference device (108, 110, 112, 114, 116, 118, 120, 122), or
- two components (10) according to any one of claims 1 to 6, and

• a means (160) for controlling the difference in magnetic flux applied to the two superconducting quantum interference elements of the first doublet (10, 108, 110, 112, 114, 116, 118, 120, 122).

8. Amplifier according to claim 7, wherein there are interposed between the two first doublets (10, 108, 110, 112, 114, 116, 118, 120, 122) and the two outputs:

• at least two second doublets comprising two superconducting quantum interference elements (10, 108, 110, 112, 114, 116, 118, 120, 122) mounted differentially and each connected to a respective one of the outputs (104, 106) of the amplifier (100), the two superconducting quantum interference elements of each second doublet (10, 108, 110, 112, 114, 116, 118, 120, 122) being chosen from:

- a component (10) according to any one of claims 1 to 8 and a direct-current superconducting quantum interference device (108, 110, 112, 114, 116, 118, 120, 122), or
- two components (10) according to any one of claims 1 to 6, and

• a means (160) for controlling the difference in magnetic flux applied to the two superconducting quantum interference elements (10, 108, 110, 112, 114, 116, 118, 120, 122) of each second doublet.

FIG.1

FIG.2

FIG.3

FIG.4

**FIG.5**

**FIG.6**

**FIG.7**

**FIG.8**

FIG.9

FIG.10

FIG.11

FIG.12

FIG.13

FIG.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP H07174834 A
- US 4149097 A
- US 5574290 A
- US 20110065585 A1
- JP S57132072 A
- US 6320369 B1
- US 4051393 A
- US 8179133 B

**Littérature non-brevet citée dans la description**

- Study on the opération of a dual channel digital superconducting quantum interference device with direct-current-powered Josephson multiplexer readout. **ERIKO TAKEDA et al.** journal Applied Physics Letters. American Institute of Physics, 20 Mars 1995, vol. 66, 1548, , 1550
- **KORNEV et al.** DC SQUID array with nonlinear inductance. *Journal of Physics : Conférence Series,* 2010, vol. 234, 042034